Europäisches Patentamt

European Patent Office

Office européen des brevets

(11) Veröffentlichungsnummer: **0 336 904**
**A2**

# (12) EUROPÄISCHE PATENTANMELDUNG

(21) Anmeldenummer: **89810249.6**

(51) Int. Cl.⁴: **G 03 F 7/20**
**B 65 G 49/00**

(22) Anmeldetag: **04.04.89**

(30) Priorität: **08.04.88 CH 1303/88**

(43) Veröffentlichungstag der Anmeldung:
**11.10.89 Patentblatt 89/41**

(84) Benannte Vertragsstaaten:
**DE ES FR GB IT NL SE**

(71) Anmelder: **DAVERIO A.G.**
**Heinrichstrasse 217**
**CH-8031 Zürich (CH)**

(72) Erfinder: **Maier, Willy**
**Zipfelstrasse 18**
**CH-8302 Kloten (CH)**

**Bachmann, Thomas**
**Birmensdorferstrasse 407**
**CH-8055 Zürich (CH)**

**Konrad, Martin**
**Binderweg 6**
**CH-8046 Zürich (CH)**

**Staub, Markus**
**Untere Laettenstrasse 2**
**CH-8954 Geroldswil (CH)**

(74) Vertreter: **Groner, Manfred et al**
**Patentanwalts-Bureau Isler AG Walchestrasse 23**
**CH-8006 Zürich (CH)**

(54) **Einrichtung zum Fördern von Druckplatten.**

(57) Flexible Druckplatten (5) werden von einer Druckplatten-herstellungsmaschine (A) hergestellt und mittels einer Ueber-gabestation (4) mit mehreren Einheiten (C,D,E) an Greifer (24) übergeben. Diese können mittels Kulissen (2) verschwenkt und geöffnet werden und sind an einer endlosen Rollenkette (6) befestigt. Die Druckplatten (5) werden zu einer Entladestation (7) mit ebenfalls mehreren Einheiten (F,G) gebracht, wo die Greifer (24) in einem Entnahmekopf (13) pneumatisch geöffnet und die Druckplatten (5) in einen Trichter geworfen werden. Unter jedem Entnahmekopf (13) befindet sich ein Plattenstapler (10) in welchem drei Sortierwagen (10) untergebracht sind, mit denen die Druckplatten (5) in die Fächer geleitet werden.

Fig. 1

EP 0 336 904 A2

Bundesdruckerei Berlin

**Beschreibung**

## Einrichtung zum Fördern von Druckplatten

Die Erfindung betrifft eine Einrichtung nach dem Oberbegriff des unabhängigen Patentanspruchs 1.

Im Stand der Technik sind Fördereinrichtungen bekannt, die Behälter mit Eigenantrieb aufweisen, welche in einer Profilschiene fahren. Die Behälter werden von Hand mit den Druckplatten beladen und steuern programmiert selbständig ein Ziel an, wo die Platten wieder von Hand aus dem Behälter genommen werden müssen. Da in einer Druckerei solche Druckplatten unregelmässig und häufig auch nachts anfallen, ist die manuelle Bedienung einer solchen Fördereinrichtung besonders aufwendig. Empfindliche Druckplatten, insbesondere die aus Kunststoff bestehenden Flexoplatten, erfordern eine besonders sorgfältige Behandlung, was nach dem Stand der Technik oft nicht gewährleistet ist.

Bekannt sind auch Bandförderer, bei denen auf einem Band fahrende Kisten ebenfalls von Hand mit den Druckplatten beladen und entladen werden. Auch hier bestehen die oben erwähnten Schwierigkeiten.

Der Erfindung liegt die Aufgabe zugrunde, eine Einrichtung der eingangs genannten Gattung zu schaffen, die selbsttätig Druckplatten aufnimmt, fördert und wieder abgibt. Die Einrichtung soll sich insbesondere zum Fördern von flexiblen Druckplatten, sogenannten "Flexoplatten" eignen.

Die Aufgabe wird durch die Erfindung gemäss Anspruch 1 gelöst.

Die erfindungsgemässe Einrichtung nimmt die Druckplatten selbsttätig von der Vorrichtung auf, welche diese Druckplatten herstellt und gibt sie auch selbsttätig wieder ab. Die Druckplatten liegen dann in der Nähe der Falzapparate zum Gebrauch bereit. Da die Druckplatten fliegend aufgenommen und abgegeben werden, muss die Förderkette nicht gestoppt werden, was einen besonders schnelle Förderung ermöglicht. Die Förderkette kann aufgrund ihrer Verdrehbarkeit im wesentlichen beliebig steigend und fallend sowie bogenförmig geführt werden. Da beim Fördern von "Flexoplatten" die gefalzten Ränder senkrecht zum erfassten Rand verlaufen, versteifen die Falze die Platten, die auch bei schneller Bewegung kaum knicken und flattern können.

Es können auch Druckplatten mit ungewöhnlichem oder sehr grossem Format ohne Aenderungen an den Greifern gefördert werden. Indem die Kette in den geraden Bereichen liegend in der Profilschiene geführt ist und hier somit auf den Rollen läuft, ist die Abnützung der Kette klein und der Leistungsverbrauch des Antriebs niedrig.

Ein Ausführungsbeispiel der Erfindung wird nachfolgend anhand der Zeichnungen näher erläutert. Es zeigen:

Fig. 1 eine perspektivische, schematische Darstellung einer erfindungsgemässen Einrichtung,

Fig. 2 eine Ansicht eines teilweise geschnittenen Greifers,

Fig. 3 und 4 Ansichten teilweise geschnittener Greiferteile,

Fig. 5 einen Schnitt durch eine Profilschiene mit einem Greifer, der eine flexible Druckplatte fasst und eine Kulisse in Ansicht und

Fig. 6 eine perspektivische, schematische Ansicht einer Entladestation.

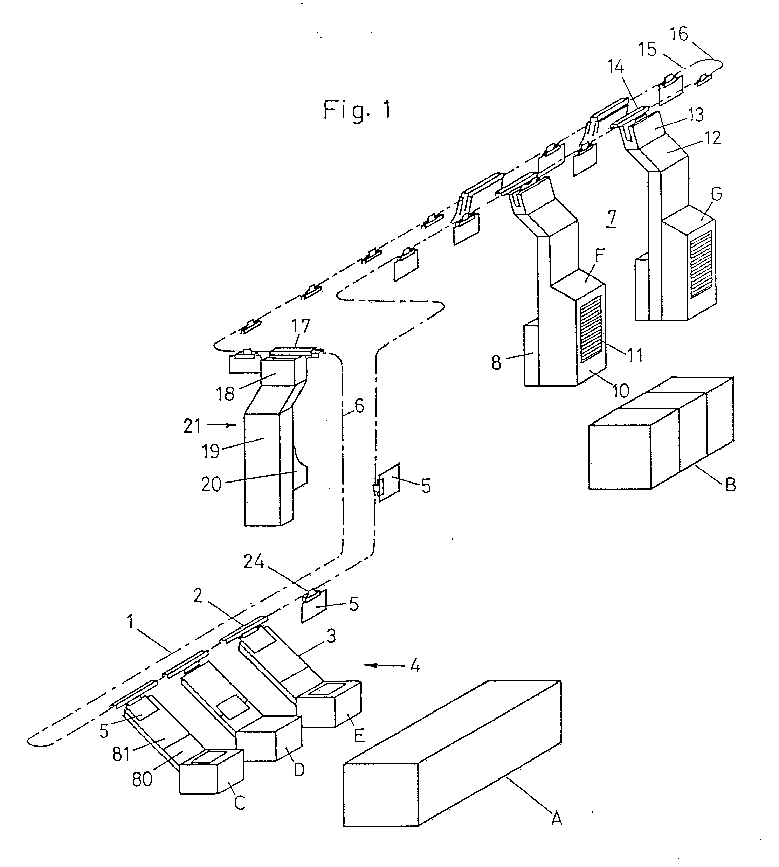

Die Fig. 1 zeigt schematisch eine erfindungsgemässe Einrichtung mit der flexible Druckplatten 5 von einer Druckplattenherstellungsmaschine A zu einer oder mehreren Falzapparaten B einzeln gefördert werden. Die Druckplatten 5 werden somit vom Herstellungsraum in den Rotationsraum gefördert, die sich auf verschiedenen Stockwerken befinden können. In der Nähe der Druckplattenherstellungsmaschine A befindet sich eine Uebergabestation 4, welche die Druckplatten 5 von der Plattenherstellungsmaschine A übernimmt und diese in eine Uebergabeposition bringt, wo sie von Greifern 24 übernommen werden. Die Uebergabestation 4 besteht aus drei Einheiten C-E die jeweils hier nicht näher dar gestellt, eine Lichtschranke aufweisen, die beim Durchlauf einer Druckplatte eine Einlauftaktkette startet, welche die Druckplatte 5 in eine Schläglage von ca. 45° fördert. Nachdem die Druckplatte 5 auf einem ansteigenden Bereich 3 etwa 180 mm gefördert worden ist, wird sie von schneller laufenden Rollen erfasst und von der Einlauftaktkette weggezogen und erreicht am Ende des Bereichs 3 ihre Uebergabeposition. In dieser wird sie durch hier nicht dargestellte Druckluftdüsen fixiert und eine Lichtschranke gibt ein Signal für die Uebergabebereitschaft der Druckplatte 5.

Die in Uebergabebereitschaft stehende Druckplatte 5 wird von einer Förderkette 1, an der die Greifer 24 im Abstand von etwa zwei Meteren schwenkbar angebracht sind zu einer Entladestation 7 transportiert. Liegt eine Druckplatte 5 zur Uebernahme bereit, wie dies bei den Einheiten C und E der Fall ist, so werden die Greifer 24 durch eine Kulisse 2 in eine Schräglage von etwa 45° gebracht und geöffnet. Im Durchlauf wird nun die Druckplatte 5 durch Schliessen des Greifers 24 erfasst und vom Uebergabetisch gezogen, wonach sie in eine vertikal hängende Lage gebracht und so transportiert wird. Die Geschwindigkeit der Förderkette 1 wird hierbei nicht geändert. Laufen mit Druckplatten 5 belegte Greifer 24 in die Uebergabestation 4 ein, so werden diese nicht geschwenkt, sondern passieren diese vertikal hängend.

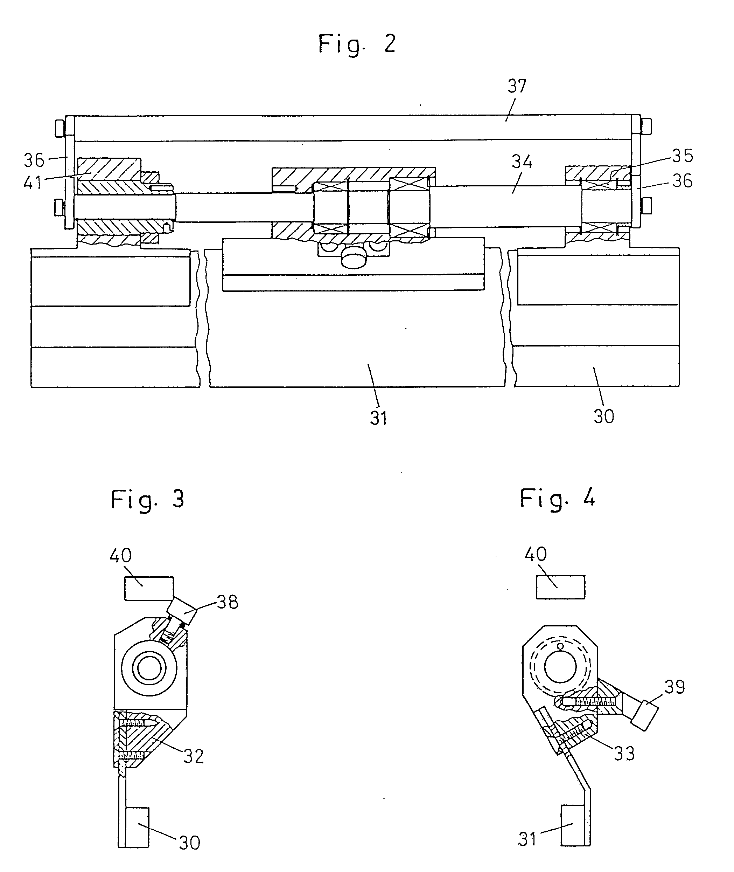

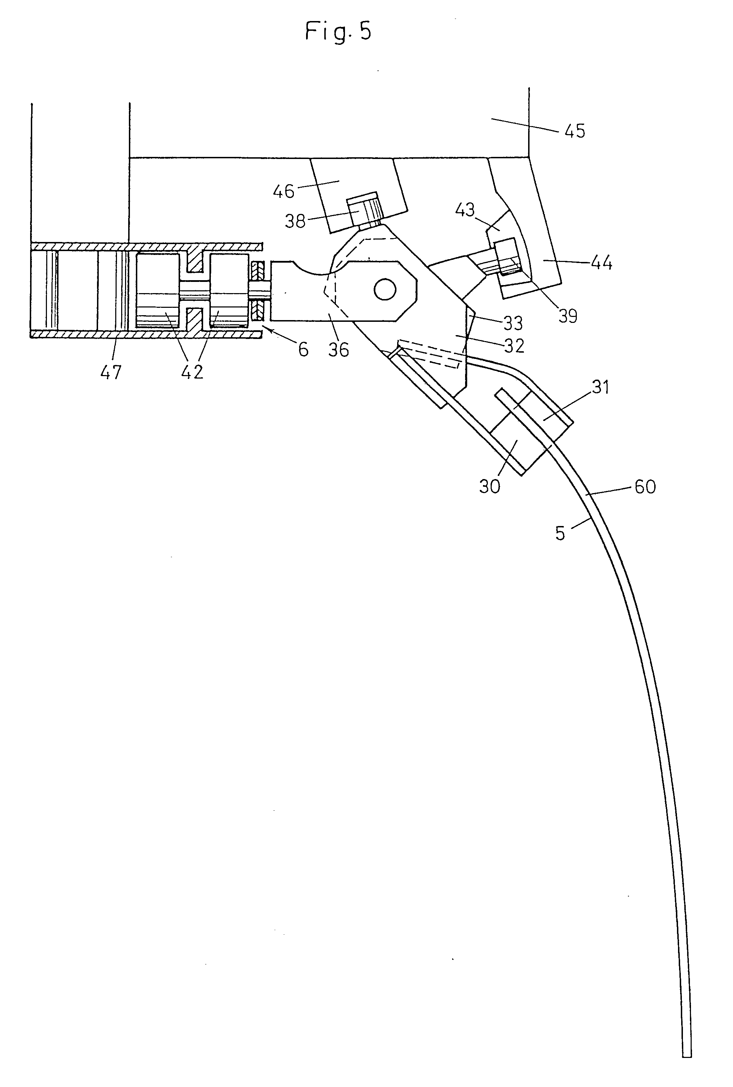

Anhand der Figuren 2 bis 5 soll der Aufbau eines Greifers 24 näher erläutert werden. An den Enden einer Verbindungsstange 37 sind Platten 36 befestigt, an denen eine Achse 34 abgebracht ist. Wie in Fig. 5 gezeigt, ist der Greifer 24 mit der Verbindungsstange 37 an Gliedern einer Rollenkette 6 befestigt. An der Achse 34 sind zwei Klemmbacken 32 und 33 schwenkbar gelagert, die mit einer hier nicht gezeigten Spiralfeder in der geschlossenen Lage gehalten werden. An den freien Enden der Klemmbacken 32 sind Gummistreifen 30 und 31 angebracht, mit denen eine Druckplatte 5 gefasst werden.

Die Klemmbacke 33 weist eine Kurvenrolle 32 auf, die zum Oeffnen des Greifers 24 auf eine Fläche 43 einer Oeffnungkulisse 44 aufläuft. Die andere Klemmbacke 32 weist ebenfalls eine Kurvenrolle 38 auf. Mit dieser wird der Greifer 24 in die gewünschte Schwenklage verschwenkt, wobei die Rolle 38 mit einer Schwenkkulisse 46 zusammenwirkt. Die Schwenkkulisse 46 ist beweglich und wird dann in eine wirksame Postion verschwenkt, wennn der Greifer 24 eine Druckplatte 5 aufnehmen soll. Ist der Greifer 24 bereits mit einer Druckplatte 5 belegt oder liegt keine Druckplatte 5 zur Uebergabe bereit, so verbleibt die Schwenkkulisse 46 in einer Lage in welche sie mit dem Greifer 24 bei seinem Durchgang nicht in Eingriff kommt. In diesem Fall passiert der Greifer 24 die betreffende Uebergabestation C, D oder E in vertikaler Lage.

Die aus Kunststoff bestehenden Druckplatten 5 weisen an gegenüberliegenden Rändern je einen Falz 60 auf. Diese verlaufen vertikal zum Rand, an dem die Druckplatten 5 vom Greifer 24 gefasst werden. Die Falze 60 versteifen die so gefassten Druckplatten 5, wodurch ein Knicken und Flattern der Druckplatten bei ihrem Transport vermieden wird. Dies gilt insbesondere auch für die weiter unten näher beschriebene Behandlung der Druckplatten in der Entladestation 7. Zu beachten ist, dass die sog. Flexoplatten sehr empfindlich sind und eine auch nur leicht geknickte Platte völlig unbrauchbar ist.

Die an sich bekannte Rollenkette 6 weist Rollen 42 auf, die zum grössten Teil wie in Fig. 5 gezeigt liegend in einer Schiene 47 laufen. Insbesondere im Umlenkbereich 16, wo ein hier nicht gezeigter Antrieb und eine Spannstation angeordnet sind, ist die Schiene 47 um ihre Längsachse um 90° gedreht, so dass die Rollenkette 6 in der Schiene 47 hängt. Dadurch kann die Rollenkette 6 geschont werden und sind zudem Umlenkungen mit kleinem Radius sowie senkrechte Teilstrecken möglich. Die Schiene 47 und die Kulissen 44 und 46 sind an einem Träger 45 befestigt, der wiederum an einem hier nicht gezeigten Gerüst angebracht ist.

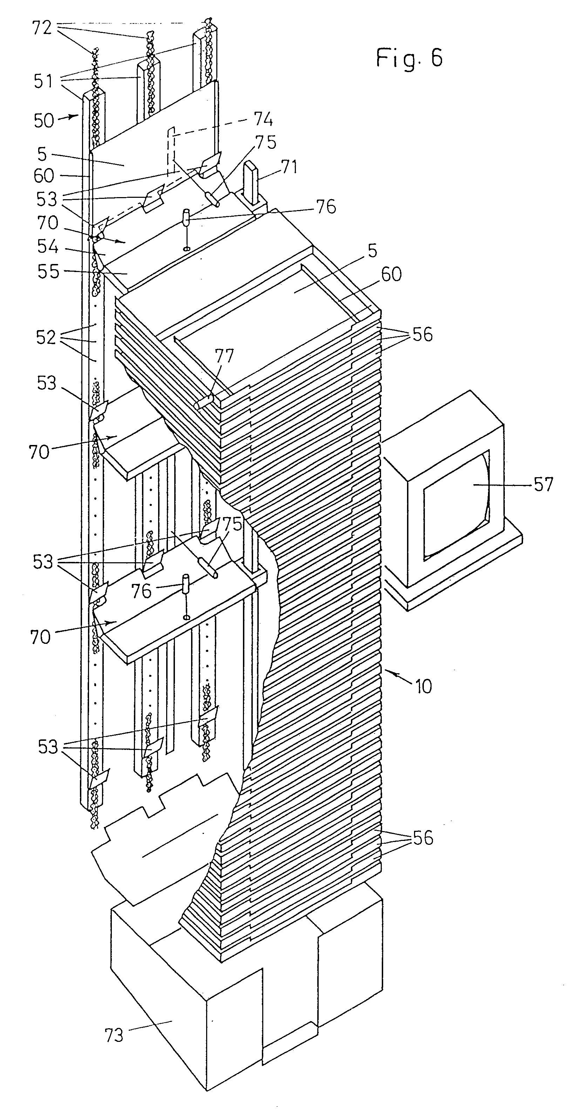

Hat ein mit einer Druckplatte 5 beladener Greifer 24 die Entladestation 7 erreicht, so wird der Greifer 24 verschwenkt und läuft in einen Entnahmekopf 13 ein. Ist der Greifer 24 nicht beladen oder soll eine Einheit F oder G der Entladestation 7 nicht berücksichtigt werden, weil diese beispielsweise keine Druckplatten 5 mehr aufnehmen kann, so wird der Greifer 24 vor dieser Einheit nicht verschwenkt und läuft hängend an dieser vorbei. Ein in den Entladekopf 13 eingefahrener Greifer 24 wird pneumatisch geöffnet und die Druckplatte 5 fällt in einen Trichter 12, und wird in diesem durch ein in Figur 6 gezeigtes Förderorgan 50 vertikal nach unten bewegt. Jede Druckplatte 5 durchläuft die Entladestation 7, der Greifer 24 wird jedoch nur dann geöffnet, wenn die Druckplatte 5 in ihrem vorbestimmten Entladekopf 13 ist. In jedem Entladekopf 13 sind die nachfolgenden, hier nicht gezeigten, Elemente angeordnet. Eine im oberen Teil angeordnete bewegliche Kulisse 14, mit welcher der Greifer 24 geöffnet werden kann. Eine Seitenklappe als Endbegrenzung für die in den Auffangtrichter fallende Druckplatte 5. Eine Bodenklappe zur unteren Begrenzung des Auffangtrichters und Abziehrollen , die den gezielten Abtransport der Druckplatten aus dem Auffangtrichter bewirken.

Jede Entladeeinheit F bzw. G weist unterhalb des Entladekopfs 13 einen Plattenstapler 10 mit Entnahmeschlitzen 11 auf, durch welche die gestapelten Druckplatten 5 entnommen werden.

Im Plattenstapler 10 werden die ihm zugeführten Druckplatten 5 in Fächer 56 eingelagert. Durch elektronisch gesteuerte Vorwahl wird für jede Druckplatte ein Fächer 56 vorbestimmt. Die Elektronik erkennt im Plattenstapler 10 freie Fächer 56 und ordnet die Druckplatten 5 diesen zu. Auf einem Bildschirm 57 ist sichtbar, in welchem der Fächer 56 sich welche Druckplatte 5 befindet. Dadurch ist es möglich, vor Beginn des Andruckes am jeweiligen Falzapparat die Druckplatten 5 sortiert einzulagern.

Wie die Figur 6 zeigt, ist der Plattenstapler 10 mit 3 Sortierwagen 70 bestückt, die an einer Führung 71 geführt sind und die ihnen zugeordneten Fächer 56 bedienen. Die Sortierwagen sind untereinander fest verbunden und haben einen fixen Abstand zueinander. Jeder Sortierwagen 70 ist mit einer Klappe 54 ausgerüstet, die in zwei Stellungen geschaltet werden kann. In der Arbeitsstellung ist die Klappe 54 eingeschwenkt und hebt die ankommende Druckplatte 5 aus den Plattenhaltern 53, die an endlosen Antriebketten 72 angebracht sind. In der anderen Stellung ist die Klappe 54 ausgeschwenkt und lässt die Druckplatte 5 passieren. Dies ist dann der Fall, wenn einer der drei Sortierwagen 70 bei einem bereits belegten Fach 56 steht oder eine nicht identifizierte Druckplatte 5 in einen Ueberlaufbehälter 73 geleitet werden muss. Die Antriebsketten 72 laufen auf Führungsschienen 51 die frontseitig Düsenöffnungen 52 besitzen. Durch einen Unterdruck in den Führungsschienen 51 werden die Druckplatten 5 an die Schienen 51 gezogen und dadurch die Druckplatten 5 in vertikaler Lage gehalten. Die Antriebsketten 72 können auch neben den Führungsschienen 51 angeordnet sein, womit die Haftung der Druckplatten noch verbessert wird. Da die Druckplatten 5 durch die gefalzten Ränder vergleichsweise steif sind, genügt ein geringer Unterdruck auf die Druckplatten 5. Der Durchlauf einer Druckplatte 5 wird mit einem ein Spiegelband 74 aufweisen Lichtschranken 75 erfasst. Mit weiteren Lichtschranken 76 und 77 wird der Einlauf der Druckplatten 5 in die Fächer 56 erkannt und wird festgestellt, welche Fächer 56 belegt bzw. frei sind.

Die Druckplatten 5 sind bei diesem Ausführungsbeispiel flexible Kunststofffolien, die unter der Bezeichnung "Flexoplatten" bekannt sind, jedoch ist nach entsprechenden Anpassungen auch der Transport von anderen Druckplatten, beispielsweise von Offsetplatten, denkbar.

In Transportrichtung nach den Entladeeinheiten F und G ist eine Entladeeinheit 21 angeordnet, bei der in einem Entladekopf 18 mittels einer Kulisse 17 alle hindurchgehenden Greifer 24 geöffnet werden. Allenfalls hier noch vorhandene Druckplatten 5 werden in jedem Fall durch einen Schacht 19 in einen Auffangbehälter 20 abgegeben. Diese Entladeeinheit 21 arbeitet ohne Lichtschranken und Vorrichtungen die ausfallen können, so dass auch bei Störungen die Greifer 24 immer leer in die Uebergabestation C-E einfahren.

**Patentansprüche**

1. Einrichtung zum Fördern von Druckplatten (5), insbesondere flexiblen Druckplatten die an gegenüberliegenden Rändern (60) gefalzt sind, mit einem endlosen Förderorgan, welches die Druckplatten (5) von einer diese herstellenden Maschine (A) zu Falzapparaten (B) fördert, dadurch gekennzeichnet, dass das Förderorgan eine auf Rollen (42) laufende, verdrehbare und in einer Führungsschiene (47) geführte Förderkette (6) ist, die in geraden Bereichen (16) liegend und an Umlenkstellen hängend ist, wobei an der Förderkette (6) in gleichen Abständen Greifer (24) befestigt sind, die in einer Uebergabestation (4) verschwenkt und geöffnet werden können und die in dieser Uebergabestation (4) fliegend je eine Druckplatte (5) aufnehmen und diese an einer Entladestation (7) ebenfalls fliegend abgeben und hierbei die Greifer (24) parallel zu einem Rand der zu fassenden Druckplatte bewegt werden.

2. Einrichtung nach Anspruch 1, dadurch gekennzeichnet, dass die Druckplatten (5) an gegenüberliegenden Rändern (60) gefalzt sind und dass die Greifer (24) in der Uebergabestation (4) und in der Entladestation (7) parallel zu einem nicht gefalzten Rand bewegt werden.

3. Einrichtung nach Anspruch 1 oder 2, dadurch gekennzeichnet, dass die Uebergabestation (4) ansteigende Bereiche (3) aufweist, in denen die Druckplatten (5) von einer ersten Förderstrecke (80) an eine verglichen mit dieser schneller fördernde zweite Förderstrecke (81) abgegeben werden.

4. Einrichtung nach einem der Ansprüche 1 bis 3, dadurch gekennzeichnet, dass die Druckplatten (5) in der Uebergabestation (4) mittels Druckluft für die Uebergabe an die Greifer (24) fixiert werden.

5. Einrichtung nach einem der Ansprüche 1 bis 4, dadurch gekennzeichnet, dass die Uebergabestation (4) Kulissen (2) aufweist, in welchen die Greifer (24) zur Aufnahme einer Druckplatte (5) zuerst verschwenkt und dann geöffnet werden.

6. Einrichtung nach einem der Ansprüche 1 bis 5, dadurch gekennzeichnet, dass die Entladestation (7) Kulissen (14) aufweist, in welchen die Greifer (24) zuerst verschwenkt und nachher pneumatisch geöffnet werden.

7. Einrichtung nach Anspruch 6, dadurch gekennzeichnet, dass unterhalb jeder Kulisse (14) ein Entladekopf (13) angebracht ist, in dem die Druckplatten (5) einzeln aufgefangen werden.

8. Einrichtung nach einem der Ansprüche 1 bis 7, dadurch gekennzeichnet, dass die Entladestation (7) Plattenstapler (10) aufweist, in denen die Druckplatten (5) mit einem oder mehreren Sortierwagen (70) an vorbestimmten Fächern (56) aufgenommen und in diese Fächer (56) geleitet werden.

9. Einrichtung nach Anspruch 8, dadurch gekennzeichnet, dass der bzw. die Sortierwagen (70) mit je einer Klappe (54) augerüstet sind, die in zwei Stellungen geschaltet werden können, wobei in der Arbeitsstellung eine ankommende Druckplatte (5) an einem unteren Rand hintergriffen und in ein Fach (56) gelenkt wird.

10. Einrichtung nach Anspruch 8 oder 9, dadurch gekennzeichnet, dass im Plattenstapler (10) etwa vertikal verlaufende Führungsschienen (51) mit Düsenöffnungen (52) angeordnet sind, wobei in den Führungsschienen (51) ein Unterdruck herrscht und die Druckplatten (5) an diesen Führungsschienen (51) anliegend mittels eines Förderorgans (72) nach unten bewegt werden.

Fig. 1

Fig. 2

37

36
41

34

35
36

31

30

Fig. 3

40

38

32

30

Fig. 4

40

39

33

31

# Fig. 5

Fig. 6